# EUROPÄISCHE PATENTSCHRIFT

(11) **EP 3 972 924 B1**
(45) Veröffentlichungstag und Bekanntmachung des Hinweises auf die Patenterteilung: **07.05.2025**
(21) Anmeldenummer: 20725174.5
(22) Anmeldetag: 12.05.2020
(51) Int. Cl.: G06T 19/20, B66B 5/00

(54) **VERFAHREN UND VORRICHTUNG ZUM VISUALISIEREN VON ERSATZTEILEN**
METHOD AND DEVICE FOR VISUALISING REPLACEMENT PARTS
PROCÉDÉ ET DISPOSITIF DE VISUALISATION DES PIÈCES DE RECHANGE

(30) Priorität: 20.05.2019 EP 19175288
(43) Veröffentlichungstag der Anmeldung: 30.03.2022
(73) Patentinhaber: INVENTIO AG, 6052 Hergiswil (CH)
(72) Erfinder: NGUYEN, Khanh, 4663 Aarburg (CH); CARRIERO, Stefano, 6330 Cham (CH)
(74) Vertreter: Inventio AG
(86) Internationale Anmeldenummer: PCT/EP2020/063208
(87) Internationale Veröffentlichungsnummer: WO 2020/234052

(56) Entgegenhaltungen:
- WO-A1-2016/174486
- WO-A1-2018/193034
- JP-A- 2017 120 517
- JP-A- 2019 043 727
- US-A1- 2018 218 540
- US-A1- 2019 050 502
- US-B1- 10 223 740
- US-B2- 10 187 686

## Beschreibung

Die vorliegende Erfindung betrifft ein Verfahren und eine Vorrichtung zum Visualisieren von Ersatzteilen. Ferner betrifft die Erfindung ein Computerprogrammprodukt, welches dazu konfiguriert ist, das erfindungsgemäße Verfahren auszuführen, umzusetzen oder zu steuern, sowie ein computerlesbares Medium mit einem solchen darauf gespeicherten Computerprogrammprodukt.

Produkte wie beispielsweise komplexe Maschinen können aus einer Vielzahl von einzelnen Bauteilen bestehen. Beispielsweise aufgrund von Verschleiß oder Beschädigungen kann es notwendig werden, Bauteile zu ersetzen. Hierzu ist es typischerweise notwendig, eine Identität, eine Funktion und/oder andere charakteristische Eigenschaften eines auszutauschenden Bauteils zuverlässig zu erkennen, um es dann durch ein gleichwirkendes Ersatzteil ersetzen zu können.

Nachfolgend soll am Beispiel einer Reparatur einer Personentransportanlage wie zum Beispiel eines Aufzugs, einer Fahrtreppe oder eines Fahrsteigs erläutert werden, welche Aufgaben bzw. Probleme beim Ersetzen von Bauteilen auftreten können. Ähnliche Aufgaben- bzw. Problemstellungen können sich jedoch auch beim Austauschen von Bauteilen anderer komplexer Produkte, beispielsweise im Rahmen einer Reparatur eines Kraftfahrzeugs oder ähnlichem, stellen.

Im Falle eines Defektes an einer Personentransportanlage muss im Allgemeinen ein Wartungstechniker zu der Personentransportanlage kommen, um zu prüfen, wie der Defekt behoben werden kann. Wenn der Wartungstechniker zu dem Schluss kommt, dass ein Bauteil ersetzt werden muss, steht er vor der Aufgabe, die Identität, Funktion und/oder andere charakterisierende Eigenschaften des Bauteils zu erkennen, um ein geeignetes Ersatzteil bestellen zu können. Dies kann im Einzelfall schwierig sein, da der Wartungstechniker eine Vielzahl unterschiedlich aufgebauter Personentransportanlagen, möglicherweise von verschiedenen Herstellern, warten können soll und in diesen Personentransportanlagen diverse Bauteile verbaut sein können.

Herkömmlich kann der Wartungstechniker Zugriff auf Bauteillisten oder Kataloge haben, die beispielsweise von Herstellern der Bauteile bzw. Ersatzteile zur Verfügung gestellt werden und in denen die Bauteile charakterisiert werden. In solchen Bauteillisten werden häufig Identifikationsnummern, Funktionen und/oder Abmessungen eines Bauteils bzw. eines zugehörigen Ersatzteils angegeben. Teilweise werden auch Bilder bzw. Fotos von Bauteilen bzw. Ersatzteilen in den Bauteillisten oder Katalogen dargestellt.

Allerdings zeigt die Praxis, dass es für einen Wartungstechniker in manchen Fällen schwierig sein kann, dass zu ersetzende Bauteil korrekt zu identifizieren, um ein passendes Ersatzteil bestellen zu können. Insbesondere können sich Bauteile mit unterschiedlichen Funktionen oder unterschiedlichen sonstigen Eigenschaften optisch sehr ähnlich sehen. Trotz der optischen Ähnlichkeit können beispielsweise Anschlüsse, Abmessungen, Anbauteile oder Ähnliches im Detail verschieden sein.

Daher kann es dazu kommen, dass der Wartungstechniker versehentlich aus der Bauteilliste ein falsches Ersatzteil aussucht und bestellt und erst beim Versuch, dieses Bauteil als Ersatzteil in die defekte Aufzuganlage einzubauen, erkennt, dass das defekte Bauteil falsch erkannt wurde und somit das Ersatzteil nicht verbaut werden kann. Hierdurch kann insbesondere eine Instandsetzung der defekten Personentransportanlage verzögert werden und/oder ein Aufwand für die Wartung bzw. Reparatur signifikant erhöht werden.

US 20180218540 A1 beschreibt ein Simulationsverfahren zum Einrichten eines Objekts in einem Gebäude mit Hilfe eines 3D-Modells, welches durch ein mobiles Gerät für das Objekt erstellt und dargestellt wird, wobei die für Erstellung des 3D-Modells benötigten Daten von einer Datenbank erhalten werden können.

Es kann unter anderem ein Bedarf an einem Verfahren sowie an einer Vorrichtung bestehen, mithilfe derer es einem Wartungstechniker erleichtert werden kann, ein zu ersetzendes Bauteil zuverlässig zu identifizieren bzw. ein geeignetes Ersatzteil zu erkennen. Ferner kann ein Bedarf an einem Computerprogrammprodukt bestehen, mithilfe dessen ein solches Verfahren durchgeführt, umgesetzt oder gesteuert werden kann, sowie an einem computerlesbaren Medium mit einem solchen darauf gespeicherten Computerprogrammprodukt.

Einem solchen Bedarf kann durch den Gegenstand gemäß einem der unabhängigen Ansprüche entsprochen werden. Vorteilhafte Ausführungsformen sind in den abhängigen Ansprüchen sowie der nachfolgenden Beschreibung definiert.

Gemäß einem ersten Aspekt der Erfindung wird ein Verfahren zum Visualisieren von Ersatzteilen, nach Anspruch 1 vorgeschlagen.

Gemäß einem zweiten Aspekt der Erfindung wird ein Mobilgerät mit einem Prozessor und einem Bildschirm vorgeschlagen, wobei das Mobilgerät dazu konfiguriert ist, das Verfahren gemäß einer Ausführungsform des ersten Aspekts der Erfindung auszuführen, zu steuern oder umzusetzen.

Gemäß einem dritten Aspekt der Erfindung wird ein Computerprogrammprodukt vorgeschlagen, welches computerlesbare Anweisungen aufweist, welche bei Ausführung auf einem prozessorgesteuerten Mobilgerät dieses dazu veranlassen, das Verfahren gemäß einer Ausführungsform des ersten Aspekts der Erfindung auszuführen, zu steuern oder umzusetzen.

Gemäß einem vierten Aspekt der Erfindung wird ein computerlesbares Medium vorgeschlagen, auf dem ein Computerprogrammprodukt gemäß einer Ausführungsform des dritten Aspekts der Erfindung gespeichert ist.

Mögliche Merkmale und Vorteile von Ausführungsformen der Erfindung können unter anderem und ohne die Erfindung einzuschränken als auf nachfolgend beschriebenen Ideen und Erkenntnissen beruhend angesehen werden.

Kurz zusammengefasst kann eine der vorliegenden Erfindung zugrunde liegende Idee darin gesehen werden, Möglichkeiten, wie sie mit modernen prozessorgesteuerten Mobilgeräten wie intelligenten Mobiltelefonen (Smartphones) oder tragbaren Computern (Laptops, Netbooks, etc.) geboten werden, zu nutzen, um beispielsweise einen Wartungstechniker dabei zu unterstützen, ein geeignetes Ersatzteil für ein auszutauschendes Bauteil zu identifizieren. Dabei wird das Mobilgerät zunächst dazu eingesetzt, eine Liste möglicher Ersatzteile ähnlich wie bei einer herkömmlichen Bauteilliste oder einem Katalog auf dem Bildschirm des Mobilgeräts darzustellen. Aus dieser Liste kann der Wartungstechniker dann ein konkretes Ersatzteil, von dem er beispielsweise annimmt, dass es ein defektes Bauteil ersetzen kann, auswählen. Zu diesem konkreten Ersatzteil können anschließend zusätzliche Informationen von einem als Informationsquelle dienenden externen Server heruntergeladen werden. Diese Informationen umfassen insbesondere 3D-Daten betreffend visuell erkennbare Eigenschaften des konkreten Ersatzteils. Basierend auf diesen 3D-Daten kann das konkrete Ersatzteil dann in einer für den Wartungstechniker einfach zu interpretierenden Weise perspektivisch dargestellt werden. Dabei wird die perspektivische Darstellung zunächst in einem anfänglichen Blickwinkel visualisiert. Um es dem Wartungstechniker zu ermöglichen, dass ausgewählte konkrete Ersatzteil nicht nur aus einem Blickwinkel betrachten zu können, sondern diesen Blickwinkel variieren zu können, ist ferner vorgesehen, die aktuelle Orientierung des Mobilgeräts selbst zu überwachen und eine Veränderung dieser Orientierung als Indiz zu interpretieren, dass der Wartungstechniker das Ersatzteil aus einem der geänderten Orientierung des Mobilgeräts entsprechenden Blickwinkel sehen möchte. Dementsprechend kann in Reaktion auf die Veränderung der Orientierung des Mobilgeräts das Ersatzteil in einem geänderten Blickwinkel perspektivisch dargestellt werden, der der geänderten Orientierung entspricht. Der Wartungstechniker kann somit in einfacher und intuitiver Weise auf dem Bildschirm des Mobilgeräts das ausgewählte Ersatzteil aus verschiedenen Blickwinkeln inspizieren und gegebenenfalls dessen visuell erkennbare Eigenschaften mit dem tatsächlich zu ersetzenden Bauteil vergleichen. Erst wenn er beispielsweise sicher ist, dass das ausgewählte Ersatzteil in allen visuell erkennbaren Eigenschaften hinlänglich identisch mit dem zu ersetzenden Bauteil ist, kann er das Ersatzteil bestellen. Ein Risiko einer Bestellung eines falschen Bauteils und somit ein Aufwand zur Instandsetzung einer zu wartenden Maschine können somit minimiert werden.

Nachfolgend werden mögliche Ausgestaltungen und Details der einzelnen Verfahrensschritte des vorgestellten Verfahrens erläutert.

Das beschriebene Verfahren kann beispielsweise mithilfe eines Computerprogrammprodukts bzw. einer Applikation ("App") in einem prozessorgesteuerten Mobilgerät implementiert werden. Als Mobilgerät kann hierbei z.B. das Smartphone des Wartungstechnikers dienen. Nach einem Programmstart können beispielsweise verschiedene Vorabfragen durchgeführt werden, anhand derer erkannt werden kann, an welcher bzw. welcher Art von Personentransportanlage der Wartungstechniker aktuell arbeitet. Hieraus kann unter anderem geschlossen werden, welche Ersatzteile in einem konkreten Wartungsfall eventuell benötigt werden könnten.

Daraufhin kann eine Liste möglicher Ersatzteile erstellt werden. Diese Liste möglicher Ersatzteile kann beispielsweise eine Untermenge aus einer sehr großen Anzahl verschiedener Ersatzteile sein. In der Liste können verschiedene Informationen für jedes mögliche Ersatzteil enthalten sein. Die Informationen können in Schriftform und/oder in Form von Bildern oder Piktogrammen vorgesehen sein. Beispielsweise kann in der Liste zu jedem möglichen Ersatzteil ein zugehöriger Name oder eine zugehörige Identifikation (ID) in Form einer Zeichen- und/oder Ziffernfolge enthalten sein. Ferner können Eigenschaften des Ersatzteils schriftlich beschrieben sein. Vorzugsweise wird das Ersatzteil zusätzlich auch visuell dargestellt, beispielsweise in Form eines Fotos, einer Zeichnung, eines Piktogramms, eines Schaltbilds oder ähnlichem. Die Daten für die Liste möglicher Ersatzteile können hierbei typischerweise ein verhältnismäßig geringes Datenvolumen umfassen. Dementsprechend können diese Daten gegebenenfalls in dem Mobilgerät vorab abgespeichert worden sein. Alternativ können diese Daten situationsangepasst von einer externen Datenquelle wie beispielsweise einem mitzuführenden Datenspeicher (zum Beispiel einer CD, einem Flashspeicher oder ähnlichem) oder einem entfernten Datenspeicher wie beispielsweise einem Server oder einer Datenwolke (Cloud) heruntergeladen werden.

Die Liste möglicher Ersatzteile wird dann auf dem Bildschirm des Mobilgeräts dargestellt, beispielsweise in Form einer Liste von schriftlichen Kurzbeschreibungen und/oder visuellen Wiedergaben für jedes der Ersatzteile. Der Wartungstechniker kann sich die Liste als Gesamtheit oder in Teilen anzeigen lassen oder die Liste gegebenenfalls auch nach bestimmten Suchbegriffen, Merkmalen, oder ähnlichem durchsuchen lassen. Dabei wird der Techniker explizit oder implizit dazu aufgefordert, aus der dargestellten Liste ein konkretes Ersatzteil auszuwählen, von dem er beispielsweise annimmt, dass es ein defektes Bauteil ersetzen kann.

Nachdem auf diese Weise ein konkretes Ersatzteil ausgesucht wurde, werden zu diesem konkreten Ersatzteil 3D-Daten über ein Netzwerk von einem externen Server heruntergeladen. Unter 3D-Daten werden hierbei Daten verstanden, welche visuell erkennbare Eigenschaften eines Ersatzteils räumlich, d.h. in drei Raumrichtungen, angeben. Visuell erkennbare Eigenschaften sollen hierbei optische Eigenschaften des Ersatzteils sein, welche von einem Menschen mit seinen Augen wahrgenommen werden können. Die 3D-Daten geben somit beispielsweise eine Geometrie einer Außenoberfläche, d.h. beispielsweise Abmessungen, Krümmungen, Kanten, etc. der Außenoberfläche, des konkreten Ersatzteils an. Ferner können die 3D-Daten angeben, welche Farbe, Farben oder Farbverläufe an der Außenoberfläche bzw. Teilen davon vorhanden sind. Auch andere visuell erkennbare Eigenschaften wie beispielsweise Reflexionseigenschaften (matt, glänzend, metallisch glänzend) können in den 3D-Daten angegeben sein.

Die 3D-Daten für ein Ersatzteil können dabei vorab erstellt worden sein. Beispielsweise ist es vielfach üblich, bei einer Konzipierung bzw. Entwicklung von Bauteilen geometrische Eigenschaften und/oder Oberflächeneigenschaften in Form von CAD-Daten (Computer Aided Design) anzugeben. 3D-Daten eines Ersatzteils in Form von CAD-Daten können somit beispielsweise bei einem Hersteller des Ersatzteils bereits vorliegen und in einer Datenbank zum Herunterladen bereitgehalten werden. Dabei können CAD-Daten die visuell erkennbaren Eigenschaften eines Objekts vorteilhaft in einer Weise angeben, die es ermöglicht, das Objekt ohne übermäßigen Aufwand hinsichtlich vorzuhaltenden Datenspeichers und/oder Rechenkapazität aus verschiedenen Blickwinkeln perspektivisch darstellen zu können. Beispielsweise können geometrische Eigenschaften des Objekts vektororientiert angegeben sein.

Alternativ können 3D-Daten eines Ersatzteils auch in anderer Weise ermittelt werden, beispielsweise mithilfe eines räumlichen optischen Abtastens (3D-Scan), räumlicher Fotografie oder ähnlichem.

Die 3D-Daten können hierbei ein erhebliches Datenvolumen aufweisen. Insbesondere kann das Datenvolumen von 3D-Daten für ein Ersatzteil deutlich größer sein als ein Datenvolumen der dieses Ersatzteil betreffenden Daten in der zuvor darzustellenden Liste möglicher Ersatzteile. Außerdem können Ersatzteile hinsichtlich ihrer visuellen Eigenschaften mit der Zeit Änderungen erfahren, beispielsweise aufgrund von technischen Weiterentwicklungen, Änderungen in Designvorgaben, etc., sodass diesbezügliche 3D-Daten kontinuierlich aktualisiert gehalten werden sollten.

Dementsprechend kann es unvorteilhaft sein, die 3D-Daten direkt in dem Mobilgerät einzuspeichern und von dort bei Bedarf aus einem Speicher dann auszulesen. Stattdessen sollen die 3D-Daten im Allgemeinen in einem externen Server gespeichert sein. Ein solcher Server kann Teil einer Datenwolke (Cloud) sein. Dabei kann sich der Server weit entfernt von einer aktuell zu wartenden Anlage oder Maschine befinden. Die 3D-Daten können dann beispielsweise von einem Hersteller oder Entwickler von Ersatzteilen bereitgestellt und/oder aktualisiert bzw. gepflegt werden.

Von dem externen Server können die 3D-Daten dann bei Bedarf heruntergeladen werden. Dies kann über ein Netzwerk wie beispielsweise das Internet erfolgen. Insbesondere kann das Herunterladen über ein drahtloses Netzwerk wie beispielsweise ein Funknetz erfolgen. Prozessorgesteuerte Mobilgeräte verfügen in der Regel über drahtlose Datenschnittstellen (z.B. WLAN, 3G/4G-Mobilfunk, etc.), über die das Herunterladen der 3D-Daten problemlos durchgeführt werden kann.

Nachdem die 3D-Daten in dem prozessorgesteuerten Mobilgerät verfügbar sind, kann das konkret ausgewählte Ersatzteil mit seinen visuell erkennbaren Eigenschaften auf dem Bildschirm dieses Mobilgeräts perspektivisch dargestellt werden. Unter einer perspektivischen Darstellung kann hierbei eine Darstellung verstanden werden, bei der das Ersatzteil zwar auf einem lediglich 2-dimensionalen Bildschirm visualisiert wird, dabei aber die räumlichen, d.h. 3-dimensionalen, Eigenschaften des Ersatzteils in einer Weise perspektivisch wiedergegeben werden, wie dies bei einem Blick auf das tatsächlich 3-dimensionale Ersatzteil der Fall wäre. Anders ausgedrückt stellt die perspektivische Darstellung eine Abbildung, d.h. ähnlich wie ein Foto, des 3-dimensionalen Ersatzteils in einem vorgegebenen Blickwinkel dar.

Dem Wartungstechniker soll jedoch nicht nur die Möglichkeit gegeben werden, dass konkret ausgewählte Ersatzteil lediglich aus dem beispielsweise zufällig vorgegebenen anfänglichen Blickwinkel dargestellt zu bekommen. Stattdessen kann es für den Wartungstechniker hilfreich sein, dass Ersatzteil aus verschiedenen Blickwinkeln darstellen zu lassen, um es beispielsweise mit dem realen, zu ersetzenden Bauteil vergleichen zu können.

Um dies in einer für den Wartungstechniker intuitiven und leicht durchzuführenden Weise ermöglichen zu können, wird vorgeschlagen, die aktuelle Orientierung des prozessorgesteuerten Mobilgeräts bzw. Veränderungen dieser aktuellen Orientierung kontinuierlich oder in kurzen Zeitabständen zu erfassen. Beispielsweise kann das Mobilgerät von dem Wartungstechniker anfänglich in einer bestimmten Orientierung gehalten werden und dabei das Ersatzteil in dem anfänglichen Blickwinkel auf dem Bildschirm des Mobilgeräts dargestellt werden. Wenn der Wartungstechniker anschließend sein Mobilgerät schwenkt, dreht oder in anderer Weise dessen Orientierung ändert, kann dies von dem Mobilgerät selbst erkannt werden und als Indiz verstanden werden, dass der Wartungstechniker wünscht, dass Ersatzteil aus einem anderen Blickwinkel dargestellt zu bekommen.

Beispielsweise sind in modernen Mobilgeräten häufig Beschleunigungssensoren integriert, welche Signale generieren, die angeben, in welche Richtung das Mobilgerät aktuell beschleunigt wird. Solche Beschleunigungssensoren können vorzugsweise Beschleunigungen in allen Raumrichtungen erfassen. Durch geeignete Analyse der Signale solcher Beschleunigungssensoren kann dann auf eine Änderung der Orientierung des Mobilgeräts rückgeschlossen werden. Ferner können auch Verlagerungen des Mobilgeräts erkannt werden.

Basierend auf der Kenntnis der erfassten Orientierungsänderung des Mobilgeräts kann anschließend das ausgewählte Ersatzteil mit seinen visuell erkennbaren Eigenschaften auf dem Bildschirm des Mobilgeräts unter einem geänderten Blickwinkel perspektivisch dargestellt werden. Der geänderte Blickwinkel kann hierbei korrespondierend zu der geänderten Orientierung des Mobilgeräts gewählt sein. Anders ausgedrückt kann der geänderte Blickwinkel sich in Relation zu dem anfänglichen Blickwinkel in gleicher oder ähnlicher Weise verhalten wie die geänderte Orientierung des Mobilgeräts in Relation zu der anfänglichen Orientierung des Mobilgeräts. Winkeländerungen der Orientierung des Mobilgeräts können dabei Winkeländerungen bei den Blickwinkel entsprechen oder zumindest in eindeutiger Weise mit diesen skalieren.

Der Wartungstechniker kann somit durch gezieltes Umorientieren seines Mobilgeräts verschiedene Blickwinkel auf das auf dem Bildschirm perspektivisch dargestellte Ersatzteil erlangen.

Eventuell kann vorgesehen sein, dass das Mobilgerät zunächst in eine bestimmte Anfangsorientierung gebracht werden kann, bevor von dieser Anfangsorientierung ausgehend Veränderungen bei der Orientierung des Mobilgeräts erfasst werden. Die Anfangsorientierung kann beispielsweise so gewählt werden, dass für den Wartungstechniker ein Blick auf das reale Bauteil unter einem Blickwinkel erscheint, der dem anfänglichen Blickwinkel auf das auf dem Bildschirm virtuell perspektivisch dargestellte Ersatzteil entspricht. Wenn der Wartungstechniker beispielsweise diese Orientierung des Mobilgeräts als Anfangsorientierung festlegt, kann er anschließend zum Beispiel das reale Bauteil aus verschiedenen Blickwinkeln betrachten und dabei sein Mobilgerät entsprechend mitführen und umorientieren, um auf dessen Bildschirm das ausgewählte Ersatzteil in einer korrespondierenden perspektivischen Darstellung in einem entsprechenden Blickwinkel visualisiert zu bekommen. Der Wartungstechniker kann somit das reale Bauteil sehr einfach mit dem ausgewählten Ersatzteil unter verschiedenen Blickwinkeln vergleichen.

Um dem Wartungstechniker ergänzend eine weitere Möglichkeit zu geben, um den virtuellen Blickwinkel auf das auf dem Bildschirm dargestellte Ersatzteil verändern zu können, können ergänzend Berührungen des Bildschirms des prozessorgesteuerten Mobilgeräts erfasst werden und eine Größe und/oder Orientierung der perspektivischen Darstellung des ausgewählten Ersatzteils in Abhängigkeit von den erfassten Berührungen verändert werden.

Beispielsweise kann der Bildschirm des Mobilgeräts berührungsempfindlich sein, d.h. als Touchscreen ausgebildet sein. Mithilfe eines solchen Bildschirms können Berührungen des Bildschirms, die ein Techniker beispielsweise mit seinen Fingern bewirkt, erkannt werden. Insbesondere können Bewegungen von Fingern auf dem Bildschirm erkannt werden. Diese Bewegungen können dann analysiert und als Indiz dafür erkannt werden, dass der Wartungstechniker eine perspektivische Darstellung des ausgewählten Ersatzteils aus einem anderen Blickwinkel und/oder in einer anderen Größe wünscht.

Beispielsweise kann der Wartungstechniker einen Bezugspunkt auf dem Bildschirm mit seinem Finger berühren und dann verschieben, um den gewünschten Blickwinkel zu verändern. Ferner kann der Wartungstechniker beispielsweise mit zwei Fingern einen Bereich markieren und durch Bewegen der beiden Finger relativ zueinander angeben, dass eine vergrößerte oder verkleinerte Darstellung des Ersatzteils gewünscht ist. Hierdurch kann der Wartungstechniker beispielsweise den anfänglichen Blickwinkel, mit dem das Ersatzteil auf dem Bildschirm anfangs perspektivisch dargestellt wird, derart verändern und die Größe der perspektivischen Darstellung derart anpassen, dass sie dem Blick des Wartungstechnikers auf das reale auszutauschende Bauteil entsprechen, um somit einen visuellen Vergleich des realen Bauteils und des virtuell dargestellten Ersatzteils zu vereinfachen.

Gemäß einer Ausführungsform kann das hierin vorgestellte Verfahren zum Visualisieren eines Ersatzteils vorteilhaft ergänzt werden, indem zusätzlich ein Foto mit einer Kamera des prozessorgesteuerten Mobilgeräts aufgenommen wird und das Foto zusammen mit der perspektivischen Darstellung des konkret ausgewählten Ersatzteils auf dem Bildschirm des prozessorgesteuerten Mobilgeräts dargestellt wird.

Prozessorgesteuerte Mobilgeräte verfügen meist über eine eingebaute Kamera, mithilfe derer Fotos aufgenommen werden können. Die Kamera ist oft an einer zu dem Bildschirm entgegengesetzten Seite des Mobilgeräts angeordnet.

Für die vorliegend beschriebene Anwendung kann somit das Mobilgerät mit seiner Kamera hin zu einem auszutauschenden Bauteil gerichtet werden und dann ein Foto von dem Bauteil und gegebenenfalls einer Umgebung des Bauteils aufgenommen werden. Dieses Foto kann dann zusammen mit der perspektivischen Darstellung des zuvor konkret ausgewählten Ersatzteils auf dem Bildschirm des Mobilgeräts angezeigt werden. Hierdurch kann der Wartungstechniker auf dem Bildschirm gleichzeitig das Foto des realen Bauteils als auch die perspektivische Darstellung des ausgewählten Ersatzteils sehen und diese somit in einfacher Weise miteinander vergleichen.

Insbesondere können in einer speziellen Ausgestaltung das Foto und die perspektivische Darstellung des konkret ausgewählten Ersatzteils zumindest bereichsweise überlagernd dargestellt werden.

Anders ausgedrückt brauchen das Foto und die perspektivische Darstellung nicht separat, beispielsweise nebeneinander, dargestellt werden. Stattdessen kann es vorteilhaft sein, die perspektivische Darstellung des Ersatzteils mit dem Foto überlappen zu lassen bzw. diese in das Foto zu integrieren. Gegebenenfalls kann dem Wartungstechniker die Möglichkeit gegeben werden, die Position, an der die perspektivische Darstellung des Ersatzteils in dem Foto dargestellt werden soll, vorzugeben, beispielsweise indem er die perspektivische Darstellung durch Berührungen des Bildschirms an eine gewünschte Position zieht. Hierdurch können das Ersatzteil und das Bild des realen Bauteils besonders einfach verglichen werden.

Eventuell kann sogar vorgesehen sein, die perspektivische Darstellung des Ersatzteils und/oder das Foto teilweise durchscheinend darzustellen und die Darstellung des Ersatzteils und die Wiedergabe des realen Bauteils direkt zu überlagern. Auf diese Weise können beispielsweise Konturen des Ersatzteils und des realen Bauteils besonders gut miteinander verglichen werden.

In einer weiteren speziellen Ausgestaltung kann das Verfahren dadurch ergänzt werden, dass das Foto zusammen mit der perspektivischen Darstellung in dem geänderten Blickwinkel korrespondierend zu der geänderten Orientierung an einen externen Server übermittelt wird.

Mit anderen Worten kann dem Wartungsinstallateur die Möglichkeit gegeben werden, nicht nur ein Foto aufzunehmen und dessen Inhalt mit der perspektivischen Darstellung des ausgewählten Ersatzteils zu vergleichen, sondern, nachdem er die Orientierung des Mobilgeräts in einer gewünschten Weise geändert hat, um damit einen ihm sinnvoll erscheinenden Blickwinkel für die perspektivische Darstellung des Ersatzteils auszuwählen, das Foto zusammen mit der perspektivischen Darstellung auch an einen externen Server übermitteln zu können.

Für den Fall, dass der Wartungstechniker beispielsweise nicht ganz sicher ist, ob das ausgewählte Ersatzteil tatsächlich geeignet ist, ein defektes Bauteil zu ersetzen, kann er somit ein Foto des defekten Bauteils direkt zusammen mit dem bereits von ihm ausgewählten Ersatzteil in einer geeigneten perspektivischen Darstellung an den externen Server übermitteln. Dort können die übermittelten Bilddaten beispielsweise von Fachleuten eines Herstellers des Ersatzteils geprüft werden und dem Wartungstechniker daraufhin eine Rückmeldung darüber geliefert werden, ob das Ersatzteil tatsächlich das defekte Bauteil ersetzen kann. Eine Handhabung des Mobilgeräts zur Aufnahme und Übermittlung der entsprechenden Daten ist dabei für den Wartungstechniker besonders intuitiv.

Das Mobilgerät gemäß dem zweiten Aspekt der vorliegenden Erfindung ist ein kleines, portables Gerät, welches über eine geeignete Prozessorleistung sowie einen geeigneten Bildschirm verfügt, um 3D-Daten eines Ersatzteils perspektivisch darstellen zu können. Ferner verfügt das Mobilgerät vorzugsweise über einen Datenspeicher, in dem die 3D-Daten und eventuell auch Daten betreffend die Liste möglicher Ersatzteile abgespeichert werden können. Außerdem verfügt das Mobilgerät vorzugsweise über eine Schnittstelle, bevorzugt über eine drahtlose Schnittstelle, über die die 3D-Daten von einem externen Server heruntergeladen werden können. Schließlich verfügt das Mobilgerät ergänzend vorzugsweise über eine Beschleunigungssensorik, mithilfe derer eine aktuelle Orientierung des Mobilgeräts erfasst werden kann.

Das Mobilgerät kann dahingehend programmierbar sein, dass es mithilfe eines speziellen Computerprogrammprodukts gemäß einer Ausführungsform des dritten Aspekts der Erfindung bzw. einer App dazu in die Lage versetzt werden kann, Ausführungsformen des hierin beschriebenen Verfahrens auszuführen, zu steuern oder umzusetzen. Das Computerprogrammprodukt kann dabei in einer beliebigen, für das Mobilgerät verständlichen Computersprache programmiert sein.

Das Computerprogrammprodukt kann auf einem computerlesbaren Medium gemäß einer Ausführungsform des vierten Aspekts der Erfindung wie einem Datenträger gespeichert sein. Ein solches computerlesbares Medium kann portabel sein. Beispielsweise kann das computerlesbare Medium eine CD, eine DVD, ein Flashspeicher oder Ähnliches sein. Alternativ kann das Computerprogrammprodukt auf einem stationären Computer bzw. Server gespeichert sein, von dem es heruntergeladen werden kann. Der Server kann Teil einer Datenwolke (Cloud) sein. Das Herunterladen des Computerprogrammprodukts kann über ein Netzwerk wie beispielsweise das Internet erfolgen.

Es wird darauf hingewiesen, dass einige der möglichen Merkmale und Vorteile der Erfindung hierin mit Bezug auf unterschiedliche Ausführungsformen des Verfahrens zum Visualisieren von Ersatzteilen einerseits und eines hierfür einsetzbaren Mobilgeräts andererseits beschrieben sind. Ein Fachmann erkennt, dass die Merkmale in geeigneter Weise kombiniert, angepasst oder ausgetauscht werden können, um zu weiteren Ausführungsformen der Erfindung zu gelangen.

Nachfolgend werden Ausführungsformen der Erfindung unter Bezugnahme auf die beigefügten Zeichnungen beschrieben, wobei weder die Zeichnungen noch die Beschreibung als die Erfindung einschränkend auszulegen sind.

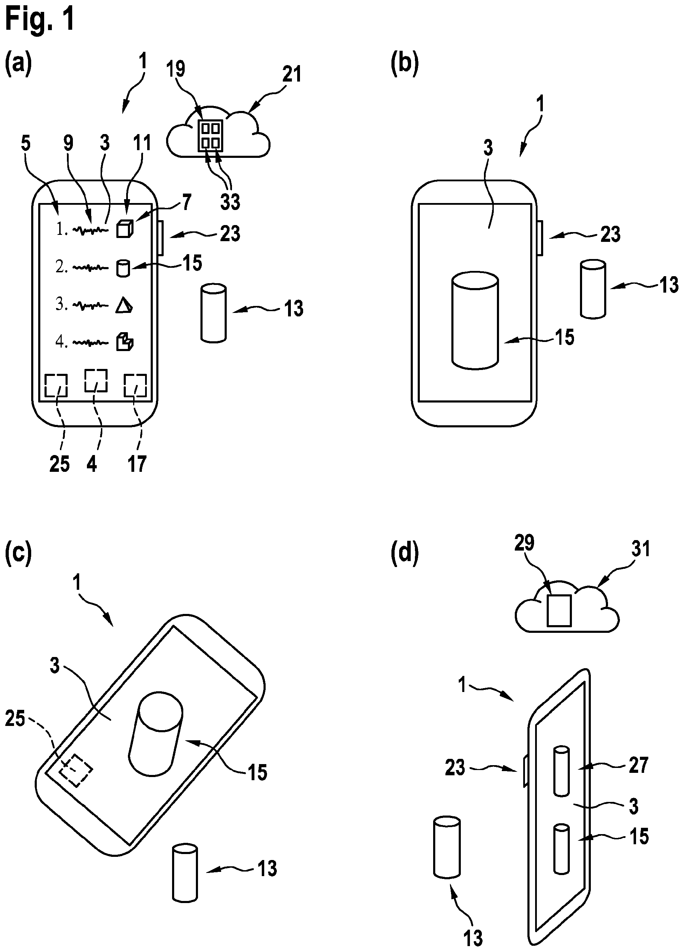

Fign. 1(a) bis (d) veranschaulichen Schritte eines erfindungsgemäßen Verfahrens zum Visualisieren von Ersatzteilen.

Die Figuren sind lediglich schematisch und nicht maßstabsgetreu. Gleiche Bezugszeichen bezeichnen in den verschiedenen Figuren gleiche oder gleichwirkende Merkmale.

Fig. 1 veranschaulicht verschiedene Schritte (a) bis (d) einer Ausführungsform eines erfindungsgemäßen Verfahrens zum Visualisieren von Ersatzteilen.

In einem ersten Schritt, wie er in Fig. 1(a) veranschaulicht ist, wird auf dem Bildschirm 3 eines durch einen Prozessor 4 gesteuerten Mobilgeräts 1 eine Liste 5 möglicher Ersatzteile 7 dargestellt. In der Liste 5 können zu jedem möglichen Ersatzteil 7 schriftliche Informationen 9 und/oder bildhafte Informationen 11 dargestellt sein.

Ein Wartungstechniker, der mit der Wartung beispielsweise einer Personentransportanlage betraut wurde und darin ein defektes Bauteil 13 ersetzen möchte, kann aus dieser Liste 5 ein konkretes Ersatzteil 15 auswählen.

Daraufhin kann das Mobilgerät 1 beispielsweise über eine Schnittstelle 17 Kontakt mit einem externen Server 19 aufnehmen, in dem 3D-Daten 33 zu einer Vielzahl von Ersatzteilen 7 gespeichert sind. Der Server 19 kann beispielsweise von einem Hersteller von Ersatzteilen 7 betrieben werden. Die 3D-Daten 33 können beispielsweise CAD-Daten sein, die der Hersteller im Rahmen einer Entwicklung und/oder Fertigung der Ersatzteile 7 erstellt hat. Der Server 19 kann Teil einer Datenwolke 21 sein. Das Mobilgerät 1 kann dann 3D-Daten 33 zu dem konkret ausgewählten Ersatzteil 15 von dem Server 19 herunterladen, vorzugsweise durch drahtlose Datenübertragung.

Wie in Fig. 1(b) veranschaulicht kann das Mobilgerät 1 anschließend visuell erkennbare Eigenschaften des ausgewählten Ersatzteils 15, wie sie in den heruntergeladenen 3D-Daten 33 definiert sind, auf dem Bildschirm 3 perspektivisch darstellen. Dabei erfolgt die perspektivische Darstellung zunächst bezogen auf einen anfänglichen Blickwinkel.

Anschließend kann der Wartungstechniker, wie in Fig. 1(c) veranschaulicht, das auf dem Bildschirm 3 des Mobilgeräts 1 dargestellte Ersatzteil 15 unter verschiedenen Blickwinkeln betrachten. Hierzu kann der Wartungstechniker das Mobilgerät 1 verlagern, insbesondere schwenken, rotieren und/oder drehen, um dessen Orientierung zu verändern. Die Orientierung des Mobilgeräts 1 in eine geänderte Orientierung kann mithilfe von Beschleunigungssensoren 25 des Mobilgeräts 1 erfasst werden. Daraufhin kann das konkret ausgewählte Ersatzteil 15 in einem der geänderten Orientierung entsprechenden geänderten Blickwinkel perspektivisch dargestellt werden.

Optional kann in einem zusätzlichen Schritt, wie er in Fig. 1(d) veranschaulicht ist, eine Kamera 23 des Mobilgeräts 1 dazu genutzt werden, um ein Foto 27 des auszutauschenden Bauteils 13 aufzunehmen. Das Foto 27 kann dann zusammen mit der perspektivischen Darstellung des zuvor konkret ausgewählten Ersatzteils 15 auf dem Bildschirm 3 dargestellt werden. Dabei können das Foto 27 und die perspektivische Darstellung des Ersatzteils 15 nebeneinander oder in einer zumindest teilweise überlappenden Weise (aus Übersichtlichkeitsgründen nicht dargestellt) visualisiert werden.

Gegebenenfalls kann das Foto 27 zusammen mit der perspektivischen Darstellung des Ersatzteils 15 von dem Mobilteil 1 an einen externen Server 29, der wiederum Teil einer Datenwolke 31 sein kann, übermittelt werden, um dort analysieren zu lassen, ob das Ersatzteil 15 wirklich das Bauteil 13 geeignet ersetzen kann.

Zusammenfassend und mit einer geänderten Wortwahl kann eine dem hierin vorgestellten Ansatz zugrunde liegende Idee darin gesehen werden, eine Art virtuelles Hologramm für jedes Ersatzteil darzustellen, um einem Feldtechniker eine Auswahl zu erleichtern. Quelldaten für das Hologramm können aus CAD-Daten stammen, wie sie zuvor für Ersatzteile erstellt wurden. Das Hologramm bzw. die perspektivische Darstellung des Ersatzteils kann auf dem Bildschirm des Mobilgeräts unter Verwendung der integrierten Kamera, Beschleunigungssensoren und Grafiksoftwaremodulen erzeugt werden. Ein bereits existierender Ersatzteilkatalog bzw. eine hierfür ausgestaltete App können erweitert werden, um Zugriff auf die 3D-Modelle jedes Ersatzteils zu erhalten. Die App wird dann das Design berechnen und es auf dem Bildschirm des Mobilgeräts zeigen, beispielsweise als ein Überlagerungsbild über einem Kamerabild. Wenn das 3D-Modell gezeigt wird, kann der Anwender sein Mobilgerät schwenken. Basierend auf Beschleunigungssensor-Werten wird die App das 3D-Modell in der entsprechenden Achse rotieren. Da der Hintergrund auf dem Bildschirm das aktuelle Kamerabild zeigt, wird der Anwender ein Gefühl eines holographischen Ersatzteils bekommen, wenn das Mobilgerät in einer Achse bewegt wird. Insgesamt kann hierdurch eine bessere Erkennbarkeit eines benötigten Ersatzteils erreicht werden, da der Anwender ein 3D-Bild des Ersatzteils und eine 360°-Ansicht desselben erhalten kann. Im Ergebnis können weniger falsche Bestellungen von Ersatzteilen vorgenommen werden und hierdurch Kosten eingespart werden und/oder Ausfallzeiten von Defekten Personentransportanlagen verkürzt werden.

Abschließend ist darauf hinzuweisen, dass Begriffe wie "aufweisend", "umfassend", etc. keine anderen Elemente oder Schritte ausschließen und Begriffe wie "eine" oder "ein" keine Vielzahl ausschließen. Ferner sei darauf hingewiesen, dass Merkmale oder Schritte, die mit Verweis auf eines der obigen Ausführungsbeispiele beschrieben worden sind, auch in Kombination mit anderen Merkmalen oder Schritten anderer oben beschriebener Ausführungsbeispiele verwendet werden können. Bezugszeichen in den Ansprüchen sind nicht als Einschränkung anzusehen.

## Patentansprüche

1. Verfahren zum Visualisieren von Ersatzteilen (7), insbesondere zum Visualisieren von Ersatzteilen (7) einer Personentransportanlage, aufweisend:
- Darstellen einer Liste (5) möglicher Ersatzteile (7) auf einem Bildschirm (3) eines prozessorgesteuerten Mobilgeräts (1) und Auffordern, ein konkretes Ersatzteil (15) aus der dargestellten Liste (5) auszuwählen;
- Herunterladen von 3D-Daten (33) des konkret ausgewählten Ersatzteils (15) von einem externen Server (19) über ein Netzwerk, wobei die 3D-Daten (33) räumliche Informationen über visuell erkennbare Eigenschaften des konkret ausgewählten Ersatzteils (15) enthalten;
- perspektivisches Darstellen des konkret ausgewählten Ersatzteils (15) mit seinen visuell erkennbaren Eigenschaften auf dem Bildschirm (3) des prozessorgesteuerten Mobilgeräts (1) in einem anfänglichen Blickwinkel;
- Erfassen einer Veränderung einer Orientierung des prozessorgesteuerten Mobilgeräts (1) in eine geänderte Orientierung, wobei die Veränderung der Orientierung des prozessorgesteuerten Mobilgeräts (1) anhand von Signalen erfasst wird, welche von Beschleunigungssensoren (25) in dem prozessorgesteuerten Mobilgerät (1) bereitgestellt werden; und
- perspektivisches Darstellen des konkret ausgewählten Ersatzteils (15) mit seinen visuell erkennbaren Eigenschaften auf dem Bildschirm (3) des prozessorgesteuerten Mobilgeräts (1) in einem geänderten Blickwinkel korrespondierend zu der geänderten Orientierung.

2. Verfahren nach Anspruch 1, ferner aufweisend:
Erfassen von Berührungen des Bildschirms (3) des prozessorgesteuerten Mobilgeräts (1) und Verändern einer Größe und/oder Orientierung der perspektivischen Darstellung des konkret ausgewählten Ersatzteils (15) in Abhängigkeit von den erfassten Berührungen.

3. Verfahren nach einem der Ansprüche 1 oder 2, ferner aufweisend:
Aufnehmen eines Fotos (27) mit einer Kamera (23) des prozessorgesteuerten Mobilgeräts (1); und
Darstellen des Fotos (27) zusammen mit der perspektivischen Darstellung des konkret ausgewählten Ersatzteils (15) auf dem Bildschirm (3) des prozessorgesteuerten Mobilgeräts (1).

4. Verfahren nach Anspruch 3, wobei das Foto (27) und die perspektivische Darstellung des konkret ausgewählten Ersatzteils (15) zumindest bereichsweise überlagernd dargestellt werden.

5. Verfahren nach einem der Ansprüche 3 und 4, ferner aufweisend: Übermitteln des Fotos (27) zusammen mit der perspektivischen Darstellung des Ersatzteils (15) in dem geänderten Blickwinkel korrespondierend zu der geänderten Orientierung an einen externen Server (29).

6. Verfahren nach einem der vorangehenden Ansprüche, wobei die 3D-Daten (33) CAD-Daten des konkret ausgewählten Ersatzteils (15) sind.

7. Verfahren nach einem der vorangehenden Ansprüche, wobei die 3D-Daten (33) von dem Server (19) über ein drahtloses Netzwerk heruntergeladen werden.

8. Mobilgerät (1) mit einem Prozessor (4), einer Kamera (23), und einem Bildschirm (3), und optional mit mindestens einem Beschleunigungssensor (25), wobei das Mobilgerät (1) dazu konfiguriert ist, das Verfahren gemäß einem der Ansprüche 1 bis 7 auszuführen, zu steuern oder umzusetzen.

9. Computerprogrammprodukt, aufweisend computerlesbare Anweisungen, welche bei Ausführung auf einem prozessorgesteuerten Mobilgerät (1) dieses dazu veranlassen, das Verfahren gemäß einem der Ansprüche 1 bis 7 auszuführen, zu steuern oder umzusetzen.

10. Computerlesbares Medium mit einem darauf gespeicherten Computerprogrammprodukt gemäß Anspruch 9.

## Claims

1. Method for visualizing replacement parts (7), in particular for visualizing replacement parts (7) of a passenger transport system, comprising:
- displaying a list (5) of possible replacement parts (7) on a screen (3) of a processor-controlled mobile device (1) and prompting for selection of a specific replacement part (15) from the displayed list (5);
- downloading 3D data (33) of the specifically selected replacement part (15) from an external server (19) via a network, wherein the 3D data (33) contain spatial information regarding visually discernible properties of the specifically selected replacement part (15);
- displaying a perspective view of the specifically selected replacement part (15) with its visually discernible properties on the screen (3) of the processor-controlled mobile device (1) from an initial viewing angle;
- detecting a change in the orientation of the processor-controlled mobile device (1) to an altered orientation, wherein the change in the orientation of the processor-controlled mobile device (1) is detected using signals provided by acceleration sensors (25) in the processor-controlled mobile device (1); and
- displaying a perspective view of the specifically selected replacement part (15) with its visually discernible properties on the screen (3) of the processor-controlled mobile device (1) from an altered viewing angle corresponding to the altered orientation.

2. Method according to claim 1, further comprising:
detecting touches on the screen (3) of the processor-controlled mobile device (1) and changing a size and/or orientation of the perspective view of the specifically selected replacement part (15) on the basis of the detected touches.

3. Method according to either of claims 1 or 2, further comprising:
capturing a photograph (27) using a camera (23) of the processor-controlled mobile device (1); and displaying the photograph (27) together with the perspective view of the specifically selected replacement part (15) on the screen (3) of the processor-controlled mobile device (1).

4. Method according to claim 3, wherein the photograph (27) and the perspective view of the specifically selected replacement part (15) are displayed superimposed at least in certain regions.

5. Method according to either of claims 3 and 4, further comprising: transmitting the photograph (27) together with the perspective view of the replacement part (15) from the altered viewing angle corresponding to the altered orientation to an external server (29).

6. Method according to any of the preceding claims, wherein the 3D data (33) are CAD data of the specifically selected replacement part (15).

7. Method according to any of the preceding claims, wherein the 3D data (33) are downloaded from the server (19) via a wireless network.

8. Mobile device (1) having a processor (4), a camera (23), a screen (3), and optionally having at least one acceleration sensor (25), wherein the mobile device (1) is configured to execute, control or implement the method according to any of claims 1 to 7.

9. Computer program product, comprising computer-readable instructions which, when executed on a processor-controlled mobile device (1), cause said mobile device to execute, control or implement the method according to any of claims 1 to 7.

10. Computer-readable medium having a computer program product according to claim 9 stored thereon.

## Revendications

1. Procédé permettant de visualiser des pièces de rechange (7), en particulier permettant de visualiser des pièces de rechange (7) d'un système de transport de personnes, présentant :
- la présentation d'une liste (5) de pièces de rechange (7) possibles sur un écran (3) d'un appareil mobile (1) commandé par processeur et l'invitation à sélectionner une pièce de rechange (15) concrète dans la liste (5) présentée ;
- le téléchargement de données 3D (33) de la pièce de rechange (15) sélectionnée concrètement à partir d'un serveur (19) externe par l'intermédiaire d'un réseau, dans lequel les données 3D (33) contenant des informations spatiales concernant des propriétés reconnaissables visuellement de la pièce de rechange (15) sélectionnée concrètement ;
- la représentation en perspective de la pièce de rechange (15) sélectionnée concrètement avec ses propriétés reconnaissables visuellement sur l'écran (3) de l'appareil mobile (1) commandé par processeur dans un angle de vue initial ;
- la détection d'une modification d'orientation de l'appareil mobile (1) commandé par processeur dans une orientation modifiée, dans lequel la modification d'orientation de l'appareil mobile (1) commandé par processeur est détectée à l'aide de signaux fournis par des capteurs d'accélération (25) dans l'appareil mobile (1) commandé par processeur ; et
- la représentation en perspective de la pièce de rechange (15) sélectionnée concrètement avec ses propriétés reconnaissables visuellement sur l'écran (3) de l'appareil mobile (1) commandé par processeur dans un angle de vue modifié correspondant à l'orientation modifiée.

2. Procédé selon la revendication 1, présentant en outre :
la détection d'effleurements de l'écran (3) de l'appareil mobile (1) commandé par processeur et la modification d'une taille et/ou d'une orientation de la représentation en perspective de la pièce de rechange (15) sélectionnée concrètement en fonction des effleurements détectés.

3. Procédé selon l'une des revendications 1 ou 2, présentant en outre :
la prise d'une photo (27) avec une caméra (23) de l'appareil mobile (1) commandé par processeur ; et la représentation de la photo (27) conjointement avec la représentation en perspective de la pièce de rechange (15) sélectionnée concrètement sur l'écran (3) de l'appareil mobile (1) commandé par processeur.

4. Procédé selon la revendication 3, dans lequel la photo (27) et la représentation en perspective de la pièce de rechange (15) sélectionnée concrètement sont représentées de manière superposée au moins dans certaines zones.

5. Procédé selon l'une des revendications 3 et 4, présentant en outre : la transmission de la photo (27) conjointement avec la représentation en perspective de la pièce de rechange (15) dans l'angle de vue modifié correspondant à l'orientation modifiée à un serveur externe (29).

6. Procédé selon l'une des revendications précédentes, dans lequel les données 3D (33) sont des données de CAO de la pièce de rechange (15) concrètement sélectionnée.

7. Procédé selon l'une des revendications précédentes, dans lequel les données 3D (33) sont téléchargées depuis le serveur (19) par l'intermédiaire d'un réseau sans fil.

8. Appareil mobile (1) comportant un processeur (4), une caméra (23), et un écran (3), et éventuellement au moins un capteur d'accélération (25), dans lequel l'appareil mobile (1) est configuré pour exécuter, commander ou mettre en œuvre le procédé selon l'une des revendications 1 à 7.

9. Produit programme informatique présentant des instructions lisibles par ordinateur qui, lorsqu'elles sont exécutées sur un appareil mobile (1) commandé par processeur, amènent celui-ci à exécuter, commander ou mettre en œuvre le procédé selon l'une des revendications 1 à 7.

10. Support lisible par ordinateur sur lequel est stocké un produit programme informatique selon la revendication 9.
